# EUROPEAN PATENT APPLICATION

(11) **EP 0 967 049 A1**
(43) Date of publication of application: **29.12.1999**
(21) Application number: 99110961.2
(22) Date of filing: 08.06.1999
(51) Int. Cl.: B24B 37/04, B24B 53/007, H01L 21/304

(54) **Polishing apparatus**

(30) Priority: 25.06.1998 JP 17938098
(71) Applicant: Speedfam Co., Ltd., Ohta-ku, Tokyo (JP)
(72) Inventor: Sugiyama, Misuo, Ayase-shi, Kanagawa-ken (JP); Nakanishi, Masayuki, Ayase-shi, Kanagawa-ken (JP); Komiyama, Takashi, Ayase-shi, Kanagawa-ken (JP)
(74) Representative: HOFFMANN - EITLE

(57) **Abstract**

A polishing apparatus capable of performing the polishing and pre-washing of a workpiece by a single unit is provided. The polishing apparatus possesses a platen (2) rotating driven by a main motor (21), a carrier (3) holding a wafer (W) and pressing the wafer (W) against a polishing pad (20) of the platen (2) while rotating, a slurry feeder (5) for supplying a slurry (S) on to the polishing pad (20) of the platen (2), and a pure water feeder (6) for supplying pure water (R) on to the polishing pad (20). By totating and pressing the wafer (W) on the polishing pad (20) of the rotating platen (2) by the carrier (3) and spraying slurry (S) from the slurry nozzle (51) of the slurry feeder (5), the wafer (W) is polished. The slurry feeder (5) stops being driven and the pure water feeder (6) is driven to spray pure water (R) from the pure water nozzle (61) to pre-wash the polished wafer (W).

## Description

### BACKGROUND OF THE INVENTION

### 1. Field of the Invention

The present invention relates to a polishing apparatus for polishing a workpiece by pressing it by a carrier against a polishing surface of a rotating platen.

### 2. Description of the Related Art

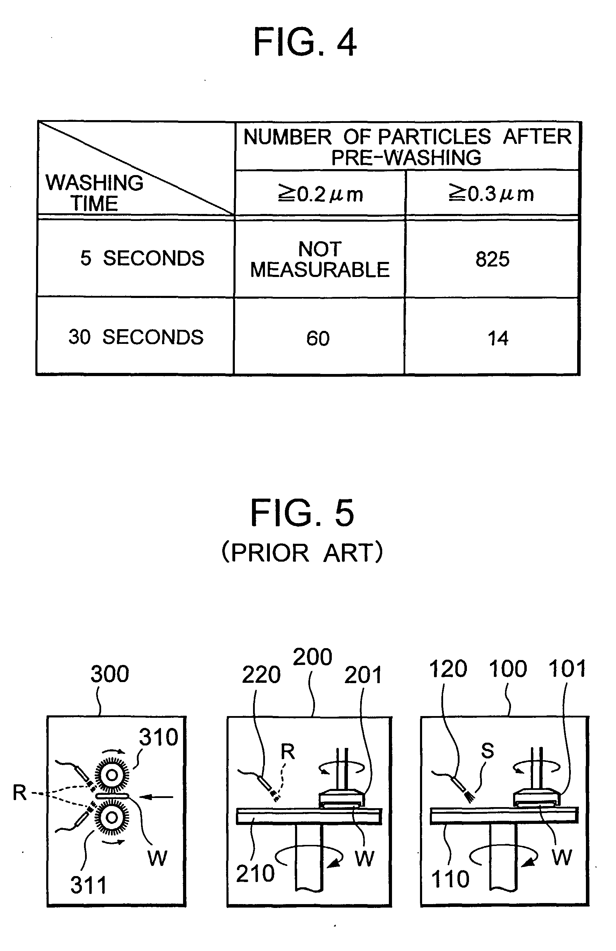

A polishing system of the related art, as shown in FIG. 5, is provided with a polishing apparatus 100, a secondary polishing apparatus 200, and a washing apparatus 300.

The polishing apparatus 100 is for polishing a workpiece, that is, the wafer W, and is provided with a carrier 101 for holding the wafer W, a platen 110 for polishing the wafer W, and a slurry feeder 120 for supplying slurry S on to the platen 110. By pressing the held wafer W against the platen 110 and making the carrier 101 rotate in that state while supplying slurry S from the slurry feeder 120 on to the platen 110, it is possible to efficiently polish the wafer W.

The secondary polishing apparatus 200 is for pre-washing the wafer W polished by the polishing apparatus 100 and is structured substantially the same as the polishing apparatus 100, but has a pure water feeder 220 instead of the slurry feeder 120. By pressing the polished wafer W against the platen 210 and making the carrier 201 rotate in that state while supplying pure water R from the pure water feeder 220 on to the platen 210, the slurry S deposited on the wafer W is washed off.

The washing apparatus 300 is for the main washing of the wafer pre-washed by the secondary polishing apparatus 200 and is provided with a rotating pair of washing brushes 310 and 311. In the washing apparatus 300, pure water R is sprayed on to the two sides of the pre-washed wafer W and the wafer is passed W between the rotating washing brushes 310 and 311 to completely wash off the slurry S deposited on the two sides of the wafer W.

In the above polishing system of the related art, however, there were the following problems.

Since two apparatuses of substantially the same structure, that is, the polishing apparatus 100 and the secondary polishing apparatus 200, were required, the cost of the system was increased by that extent. Further, it was necessary to transfer the wafer W from the polishing apparatus 100 to the secondary polishing apparatus 200, so that time required for the work became that much longer.

### SUMMARY OF THE INVENTION

The present invention was made to solve the above problems and has as its object to provide a polishing apparatus capable of performing the polishing and the pre-washing of a workpiece by a single unit.

To achieve this object, according to an aspect of the invention, there is provided a polishing apparatus comprising: a rotatable platen; a carrier for holding a workpiece and rotating while pressing the workpiece against the polishing surface of the platen; an abrasive feeder for supplying an abrasive to the polishing surface of the platen; and a washing fluid feeder for supplying a washing fluid to the polishing surface of the platen.

Due to this configuration, if the platen is made to rotate, the workpiece is held by the carrier and pressed against the polishing surface of the rotating platen while supplying an abrasive to the polishing surface of the platen from the abrasive feeder, the surface of the workpiece is polished flat by the abrasive entering between the polishing surface and the surface of the workpiece. After the end of the polishing work, the supply of the abrasive by the abrasive feeder is stopped and the washing fluid is supplied to the polishing surface of the platen from the washing fluid feeder, whereupon the abrasive entering between the polishing surface and the surface of the workpiece is washed off by the washing fluid.

The washing fluid of the washing fluid feeder may be of any type. As an example, the washing fluid is pure water.

### BRIEF DESCRIPTION OF THE DRAWINGS

The above and other objects, features, and advantages of the present invention will become more readily apparent from the following description of presently preferred embodiments of the invention taken in conjunction with the accompanying drawings, in which:
FIG. 1 is a partially cut away front view of a polishing apparatus according to a first embodiment of the present invention;
FIG. 2 is a sectional view of a pre-washing operation;
FIG. 3 is a table of the results of washing when performing a washing operation for a predetermined time changing the rotational speeds of the platen and carrier;
FIG. 4 is a table of the results of washing when performing a washing operation for a predetermined time leaving the rotational speeds of the platen and carrier constant and changing the washing time; and
FIG. 5 is a schematic view of a polishing system of the related art.

### DESCRIPTION OF THE PREFERRED EMBODIMENTS

A preferred embodiment of the present invention will be explained below with reference to the drawings.

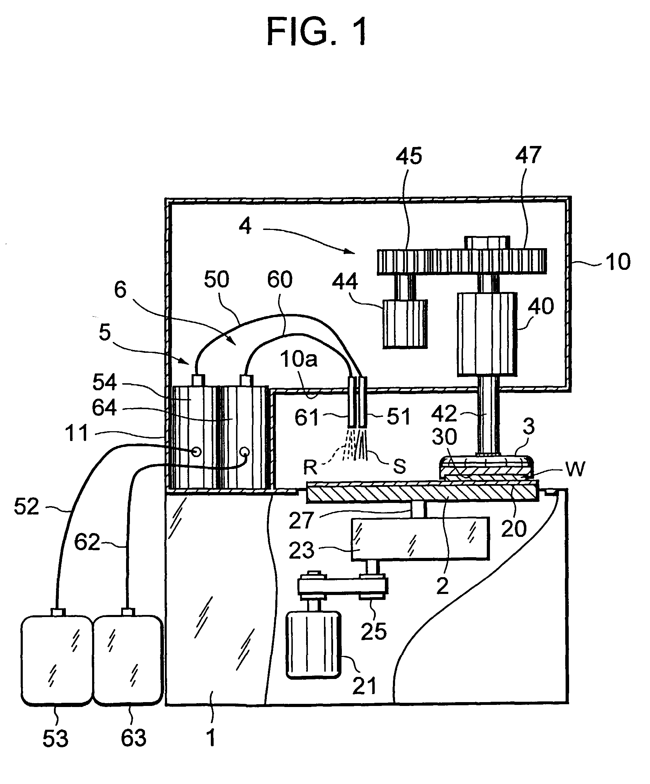

FIG. 1 is a partially cutaway front view of a polishing apparatus according to a first embodiment of the present invention.

As shown in FIG. 1, the polishing apparatus is provided with a platen 2 having a polishing pad 20 attached to the surface, a carrier 3, a slurry feeder 5 serving as the abrasive feeder, and a pure water feeder 6 serving as the washing fluid feeder.

The platen 2 is attached to the bottom part of a housing 1 and is driven to rotate by an internal main motor 21.

That is, when the main motor 21 is driven, its rotational force is transmitted to a pulley 25. The rotation of the pulley 25 is changed in speed by a speed changer 23 and transmitted to an output shaft 27 and the platen 2 rotates at a predetermined speed.

The carrier 3 is attached to the top part 10 of the housing 1. The carrier 3 has a holding hole 30 at its bottom surface for holding the wafer W serving as the workpiece and is controlled to rotate and rise and descend by a rotational drive mechanism 4.

The rotational drive mechanism 4 is for pressing against the carrier 3 to make it rotate and is provided with a cylinder 40 and a motor 44.

That is, the carrier 3 can be made to rise or descend by making a piston rod 42 move up or down by the cylinder 40.

The motor 44 is assembled to the piston rod 42 of the cylinder 40. That is, a gear 45 of the shaft of the motor 44 is engaged with a gear 47 attached to the top part of the piston rod 42. Due to the engagement of these gears 45 and 47, the rotational force of the motor 44 is transmitted to the carrier 3.

The slurry feeder 5 is for supplying a slurry S on to the polishing surface of the platen 2, that is, the polishing pad 20 and is comprised of a flexible hose 50, a slurry nozzle 51, a flexible hose 52, and a pump 54.

Specifically, the flexible hose 50 is connected to an output side of the pump 54 mounted in the columnar part 11 of the housing 11 and extends from the pump 54 to the bottom surface 10a side of the top part 10 of the housing 1. Further, the front end of the flexible hose 50 is connected to the slurry nozzle 51 attached to the bottom surface 10a of the top part 10 in a state with the spray port facing the polishing pad 20 of the platen 2. Further, the flexible hose 52 extending from the slurry tank 53 provided at the outside of the housing 1 is connected to the input side of the pump 54.

The pure water feeder 6 is for supplying pure water R on to the polishing pad 20 of the platen 2 and is comprised of a flexible hose 60, a pure water nozzle 61, a flexible hose 62, and a pump 64.

Specifically, the flexible hose 60 is connected to the output side of the pump 64 in the columnar part 11 and extends to the bottom surface 10a side of the top part 10 of the housing 1. Further, the front end of the flexible hose 60 is connected to the pure water nozzle 61 mounted at the bottom surface 10a in the state with the nozzle port facing the polishing pad 20 side. Further, the flexible hose 62 extending from the pure water tank 63 installed outside is connected to the input side of the pump 64.

Next, an explanation will be made of the operation of the polishing apparatus of the present embodiment.

First, the polishing operation can be executed.

That is, in FIG. 1, the main motor 21 is driven to make the platen 2 rotate, the carrier 3 holding the wafer W is pressed by the cylinder 40 of the rotational drive mechanism 4, and the motor 44 is driven to make the carrier 3 rotate at a predetermined speed.

In parallel with this operation, the pump 54 of the slurry feeder 5 is driven.

Due to the driving of the pump 54, the slurry S is pumped up from the slurry tank 53 outside of the housing 1 through the flexible hose 52, then flows out to the flexible hose 50. The slurry S is guided by the flexible hose 50 to the slurry nozzle 51 side and sprayed from the nozzle port of the slurry nozzle 51 toward the polishing pad 20 of the platen 2. Due to this, the wafer W is polished by the slurry S entering between the polishing pad 20 and the wafer W and the polishing pad 20.

After the end of the polishing work, the pre-washing operation can be executed.

That is, the pump 54 of the slurry feeder 5 is stopped being driven, then the rotational force of the main motor 21 and the pressing force of the cylinder 40 are adjusted to set the pressing force on the wafer W and the rotational force of the carrier 3 smaller than that at the time of the above polishing operation.

Suitably thereafter, the pump 64 of the pure water feeder 6 is driven.

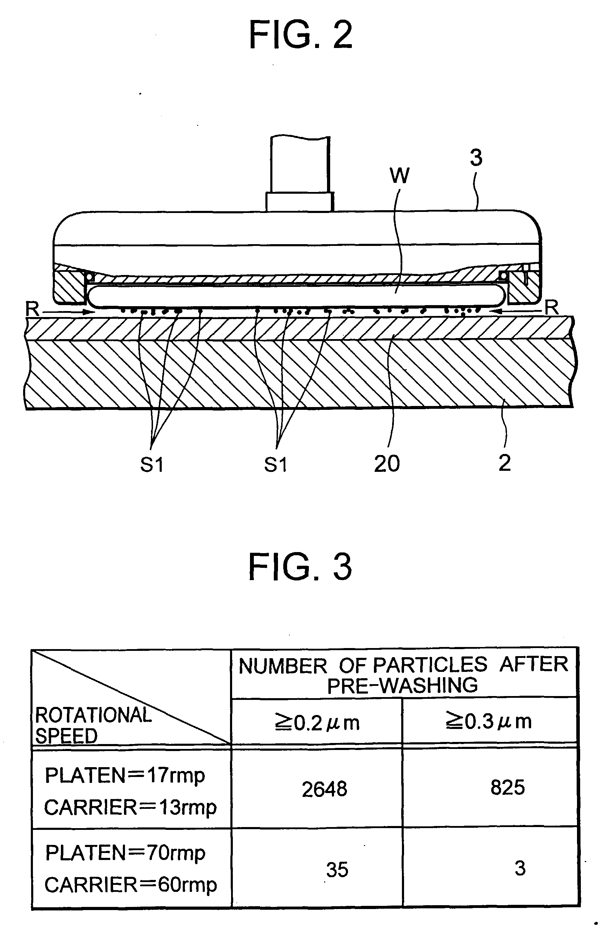

Due to the driving of the pump 64, the pure water R is pumped up from the pure water tank 63 through the flexible hose 62, then is guided by the flexible hose 60 to the pure water nozzle 61 side and is sprayed from the nozzle port of the pure water nozzle 61 toward the polishing pad 20. Due to this, as shown in FIG. 2, the pure water R enters between the polishing pad 20 and the wafer W and washes out the abrasive S1 of the slurry S deposited on the wafer W.

The pre-washing operation is performed for a predetermined time, then the main motor 21, cylinder 40, and pure water feeder 6 stop being driven to end the pre-washing operation.

Here, an explanation will be made of the effect of washing under various conditions.

FIG. 3 is a table of the results of washing when executing the washing operation for a predetermined time changing the rotational speeds of the platen 2 and carrier 3, while FIG. 4 is a table of the results of washing when leaving the rotational speeds of the platen 2 and the carrier 3 constant and changing the washing times.

First, a water W of a diameter of 600 mm is pre-washed for exactly 15 seconds to investigate the number of abrasives S1 in the slurry remaining at the wafer W after the prewashing (hereinafter called the "number of particles") . As shown in FIG. 3, when the rotational speeds of the platen 2 and the carrier 3 are set to 17 rpm and 13 rpm, respectively, there were 2648 particles of over 0.2 µm. Among these particles, there were 825 particles of over 3 µm size. Further, when the rotational speeds of the platen 2 and the carrier 3 were set to 70 rpm and 60 rpm, respectively, there were 35 particles of over 0.2 µm. Among these particles, there were only three particles of over 3 µm size. Therefore, the large part of the particles can be washed off by increasing the rotational speeds of the platen 2 and the carrier 3. The result was substantially the same as the effect of washing in the case of washing by the secondary polishing apparatus 200 shown in FIG. 5.

Next, the washing times of wafers W of the same diameter were changed when setting the rotational speeds of the platen 2 and the carrier 3 to 30 rpm and 30 rpm. This being so, as shown in FIG. 4, when the washing time is 5 seconds, a countless number of particles of over 0.2 µm remain and the number cannot be counted. However, the particles of over 0.3 µm could be measured, and there were 825 particles. When setting the washing time to 30 seconds, there were 60 particles of over 0.2 µm. Among these particles, there were 14 particles of over 0.3 µm. Therefore, by making the washing time longer, it is possible to wash off the majority of the particles. The results were also substantially the same as the washing effect when washing by the secondary polishing apparatus 200 shown in FIG. 5.

By executing the pre-washing operation of the polishing apparatus, then doing the main washing by the washing apparatus 300 shown in FIG. 5, it is possible to completely wash off the slurry S deposited on the wafer W.

In this way, according to the polishing apparatus of this embodiment, it is possible to perform the polishing work and the pre-washing work by a single polishing apparatus, so there is no need to provide a special secondary polishing apparatus 200 as in the related art. Further, it is possible to pre-wash the wafer on the same place without having to transfer a polished wafer W to the secondary polishing apparatus 200.

Note that the present invention is not limited to the above embodiment. Various modifications and changes may be made within the scope of the gist of the invention.

For example, in the above embodiment, the slurry S was used as the abrasive and pure water was used as the washing fluid, but the invention is not limited to this. It is of course also possible to use various abrasives able to polish a wafer W and possible to use various washing fluids able to wash a wafer W.

Further, in the above embodiment, the slurry nozzle 51 of the slurry feeder 5 and the pure water nozzle 61 of the pure water feeder 6 were attached to the bottom surface 10a of the top part 10 of the housing 1, but it is sufficient that they be positioned to be able to supply the slurry S and the pure water R to the polishing pad 20 of the platen 2. The locations of attachment are not limited. Further, the pumps 54 and 64 are mounted inside the columnar part 11 of the housing 1, but it is also possible to mount them at any space inside the housing 1 or outside the housing 1.

As explained in detail above, according to the present invention, it is possible to perform the polishing work and pre-washing work by a single polishing apparatus, so there are the superior effects that there is no need to specially provide a secondary polishing apparatus 200 of the related art and that it is possible to reduce the cost of the equipment by that amount. Further, it is possible to pre-wash a workpiece on the same place without transferring the polished workpiece to the secondary polishing apparatus 200 as in the related art.

## Claims

1. A polishing apparatus comprising:
a rotatable platen;
a carrier for holding a workpiece and rotating while pressing the workpiece against the polishing surface of said platen;
an abrasive feeder for supplying an abrasive to the polishing surface of said platen; and
a washing fluid feeder for supplying a washing fluid to the polishing surface of said platen.

2. A polishing apparatus as set forth in claim 1, wherein said washing fluid is pure water.
